Europäisches Patentamt

European Patent Office

Office européen des brevets

(11) Veröffentlichungsnummer: **0 629 029 A1**

(12) **EUROPÄISCHE PATENTANMELDUNG**

(21) Anmeldenummer: **94108362.8**

(22) Anmeldetag: **31.05.94**

(51) Int. Cl.⁵: **H01S 3/096**, H03K 17/04, H05B 33/08

(30) Priorität: **07.06.93 DE 4318857**

(43) Veröffentlichungstag der Anmeldung: **14.12.94 Patentblatt 94/50**

(84) Benannte Vertragsstaaten: **AT CH DE FR GB IT LI NL**

(71) Anmelder: **ANT Nachrichtentechnik GmbH Gerberstrasse 33 D-71522 Backnang (DE)**

(72) Erfinder: **Derksen, Rainer Heinrich, Dr. Weissacher Strasse 87 D-71522 Backnang (DE)**

(54) **Treiberstufe für ein optisches Sendeelement.**

㊿ Als Treiberstufen für optische Sendeelemente (LD) werden oft Stromschalter (T1, T2) mit differentieller Ansteuerung (ue) verwendet.

Anstelle einer Konstantstromquelle als Versorgungsstromquelle (Q) für den Stromschalter wird eine geschaltete Stromquelle verwendet, die beim Pegelwechsel des Ansteuersignals (ue) kurzzeitig abgeschaltet wird.

Letztere Maßnahme liefert ein verbessertes Sendesignal des optischen Senders mit einem weit geöffneten Augendiagramm.

Fig. 7

EP 0 629 029 A1

Die Erfindung geht aus von einer Treiberstufe gemäß dem Oberbegriff des Patentanspruchs 1. Solche Treiberstufen sind bekannt (EP 333 494 A2, EP 495 576 A2).

Bei Laserdioden, die über Stromschalter angesteuert werden, wird üblicherweise eine Differenzverstärkerstufe mit einem Schalttransistorpaar benutzt in dessen gemeinsamer Emitterleitung (Sourceleitung) eine Konstantstromquelle vorgesehen ist (EP 333 494 A2, EP 495 576 A2). Die EP 495 576 A2 zeigt einen Stromeinstellkreis für die Stromquelle eines Stromschalters zur Ansteuerung einer Laserdiode in der gemeinsamen Emitterleitung auf.

Aufgabe vorliegender Erfindung ist es, die Treiberstufe ausgehend vom Oberbegriff des Patentanspruchs 1 so weiterzubilden, daß gewisse Nachteile bekannter Treiberschaltungen vermieden werden. Insbesondere soll das Sendesignal eines optischen Senders, welcher mit Digitalsignalen angesteuert wird, verbessert werden.

Diese Aufgabe wird durch die kennzeichnenden Merkmale des Patentanspruches 1 gelöst. Die weiteren Patentansprüche zeigen vorteilhafte Ausgestaltungen der Erfindung auf.

Aus der Veröffentlichung "High-Speed Low-Power ECL circuit with AC-Coupled Self-Biased Dynamic Current Source and Active-Pull-Down Emitter-Follower-Stage" IEEE Journal of Solid-State Circuits, Vol. 27, No. 8, August 1992, Seiten 1207 bis 1210 ist es an sich bekannt, die Stromquelle in der Emitterleitung der Schalttransistoren des Stromschalters durch eine eigene Vorspannung zu schalten. Diese Stromquelle wird aber anders betrieben und ist anders dimensioniert. Sie dient gerade nicht zur Reduktion des Stromschalter-Stromes beim Pegelwechsel des Ansteuersignals, sondern zur kurzfristigen Erhöhung des Schaltstromes. Demzufolge kann sie keine Anregung liefern, das Sendesignal eines optischen Senders, welcher insbesondere mit Digitalsignalen angesteuert wird, zu verbessern.

Mit der erfindungsgemäßen Ausgestaltung lassen sich die Probleme beim Schalten insbesondere von Laserdioden, bei denen das Einschalten relativ rasch erfolgt und mit starkem Überschwingen der Lichtleistung verbunden ist und das Ausschalten relativ langsam ist, ohne nachteilige Auswirkungen lösen. Verschlechterungen treten bei der Verwendung von Treiberschaltungen in Stromschaltertechnik zusätzlich auf. Auch diese Nachteile lassen sich durch die erfindungsgemäße Ausbildung reduzieren.

Anhand der Zeichnungen wird die Erfindung nun näher erläutert.
Es zeigen

Fig. 1 das aussteuernde Stromsignal und die Lichtausgangsleistung einer Laserdiode nach dem Stand der Technik,

Fig. 2 Augendiagramme zu den Signalen nach Fig. 1,

Fig. 3 den prinzipiellen Aufbau einer Treiberschaltung in Stromschaltertechnik,

Fig. 4 das aussteuernde Stromsignal und die Lichtausgangsleistung einer Laserdiode bei Anwendung der Erfindung,

Fig. 5 Augendiagramme zu den Signalen nach Fig. 4,

Fig. 6 den prinzipiellen Verlauf der Ströme in den Stromschalterzweigen bei konstanter und bei gemäß der Erfindung ausgestalteter Stromquelle,

Fig. 7 ein Beispiel für eine schaltungstechnische Realisierung der geschalteten Stromquelle nach der Erfindung.

Vor der Beschreibung der eigentlichen Erfindung werden zuerst einige Voraussetzungen behandelt, um die Problemstellungen im Zusammenhang mit der Erfindung aufzuzeigen.

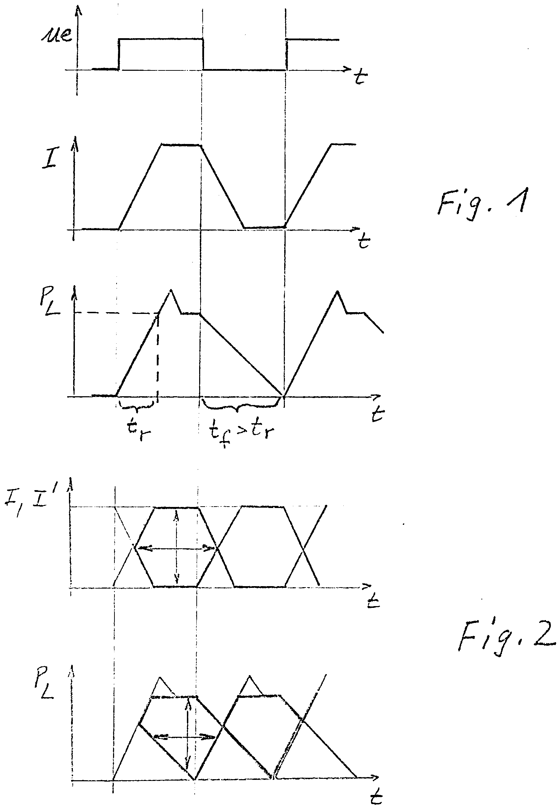

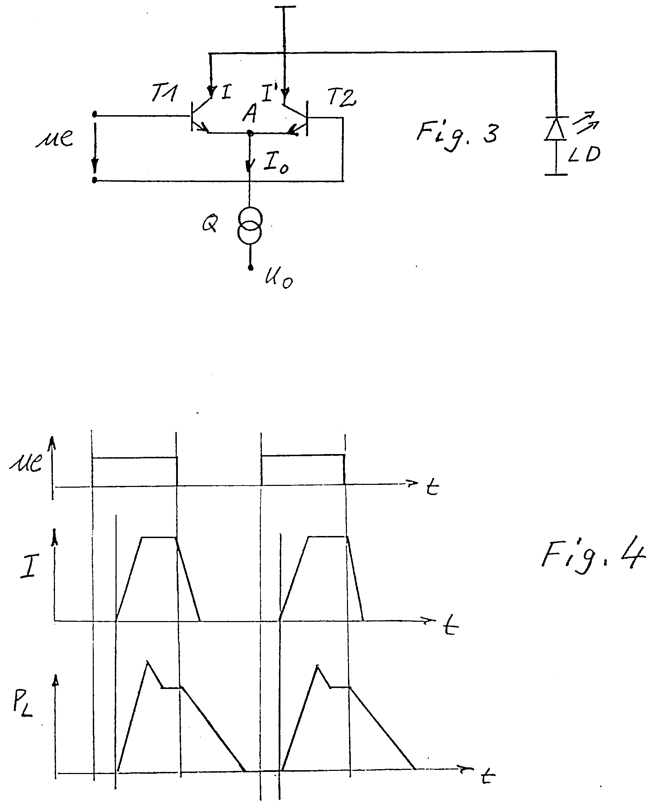

Beim Ein- und Ausschalten von Laserdioden gibt es das Problem, daß das Einschalten relativ rasch erfolgt und in der Regel mit einem starken Überschwingen im Verlauf der Lichtleistung $P_L$ verbunden ist, das Ausschalten jedoch relativ langsam ist. Vereinfacht ist dieses Verhalten in Fig. 1 dargestellt. Das Eingangssignal - Spannung ue - für den in Fig. 3 dargestellten Stromschalter besteht aus einer Rechtecksequenz (0 und 1 Pegel); der zugehörige Strom I ist trapezförmig. Die zugehörige Lichtleistung $P_L$ besitzt eine Anstiegsflanke (Zeit $t_r$), deren Steigung - idealisiert - mit der Steigung der Anstiegsflanke des Stromes I übereinstimmt, aber deren Abfallflanke (Zeit $t_f > t_r$) flacher ist als die zugehörige Abfallflanke des Stromes I. Für die gleichen Impulsformen wie in Fig. 1 sind in Fig. 2 die entsprechenden Augendiagramme dargestellt. Man erkennt, wie sich aufgrund des schnellen Einschaltens und des langsamen Ausschaltens sowohl die horizontale Augenöffnung bei der Hälfte der maximalen Leistung als auch die vertikale Augenöffnung in der "zeitlichen Mitte" des Auges verringern.

Um sehr schnelle Treiberschaltungen zu realisieren, verwendet man im allgemeinen die sogenannte Stromschaltertechnik mit differentieller Ansteuerung. Das Prinzip einer solchen Treiberschaltung zeigt Fig 3. Die Eingangsspannung ue des aus den Schalttransistoren T1, T2 bestehenden Differenzverstärkers wird deren Basen zugeführt. Die Emitter sind über den gemeinsamen Verbindungsknoten A der Stromschalterzweige zusammengeschaltet. In der gemeinsamen Emitterleitung befindet sich die mit einer Gleichspannung $U_O$ beaufschlagte Konstantstromquelle Q, die einen Strom $I_O$ führt. Die Einzelströme I und I' der Stromschalterzweige ergeben den Strom $I_O$.

Für die Stromquelle wird üblicherweise eine Transistorstromquelle verwendet wegen des günstigeren Temperaturgangs dieser Schaltung gegenüber der Verwendung eines einfachen Widerstandes und weil man im Prinzip mit geringerer Versorgungsspannung, d.h. kleinerer Verlustleistung auskommt.

Die Anstiegs- und Abfallzeiten des Ausgangsstromes I sind allerdings nicht, wie in Fig. 1 und Fig. 2 angenommen, gleich lang, vielmehr erfolgt das Einschalten des Stromes I vergleichsweise rasch und ist in der Regel auch mit einem Überschwingen verbunden, während das Abschalten des Stromes deutlich langsamer erfolgt.

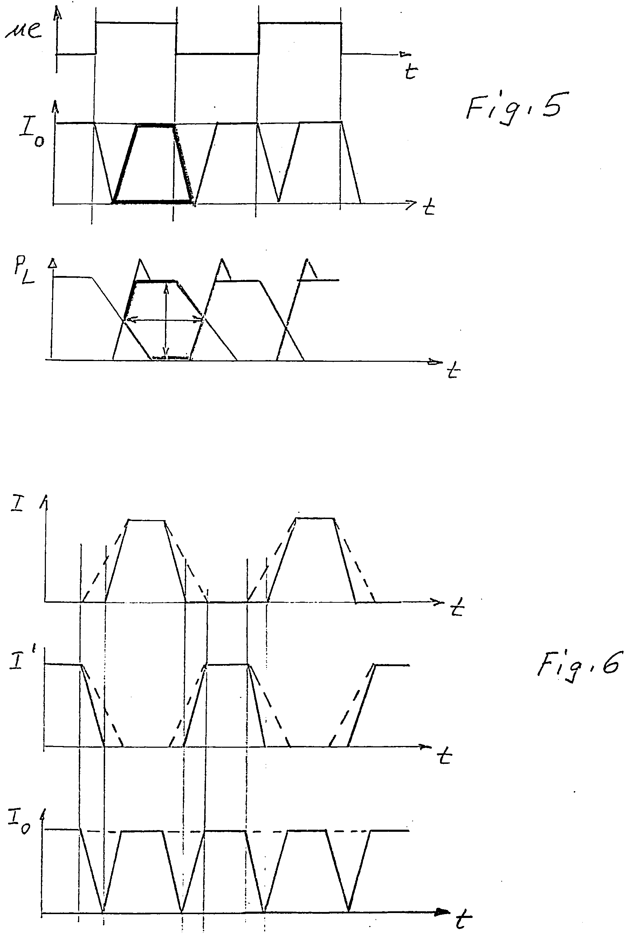

Um die geschilderte Verschlechterung des Augendiagrammes der optischen Ausgangsleistung $P_L$ aufgrund des Ein- und Ausschaltverhaltens der Laserdiode LD zu vermeiden, wird erfindungsgemäß der Signalverlauf für den ansteuernden Strom so gewählt, daß das Verhalten der Laserdiode kompensiert wird, z.B. in der Weise, daß die Schnittpunkte im Augendiagramm des ansteuernden Stromes nicht mehr bei der Hälfte des Maximalwertes liegen, sondern zu sehr kleinen Stromwerten verschoben werden. Der solcherart verbesserte Signalverlauf und der daraus resultierende Verlauf der optischen Ausgangsleistung sind schematisch in Fig. 4 dargestellt. Fig. 5 zeigt die zugehörigen Augendiagramme, und es ist zu erkennen, daß mit dem verbesserten Signalverlauf des ansteuernden Stromes eine verbesserte Augenöffnung für die optische Ausgangsleistung erreicht wird. Die maximale horizontale Augenöffnung befindet sich nun bei der Hälfte der maximalen optischen Ausgangsleistung und in der "zeitlichen Mitte" des Auges ist das Auge vertikal voll geöffnet.

Beim Betrieb der Schaltung nach Fig. 3 sieht der prinzipielle Signalverlauf für die Ströme I und I' für den Fall einer konstanten Stromquelle so aus wie in Fig. 6 gestrichelt dargestellt. Es gilt immer I + I' = $I_O$ (Stromverstärkung der Transistoren und kapazitive Ströme vernachlässigt). Wird nun die Stromquelle mit dem Pegelwechsel, d.h. Umschalten des Stromschaltereingangssignals $u_e$ zwischen 0 und 1, jeweils kurz abgeschaltet, mit dem prinzipiellen Verlauf von $I_O$ wie in Fig. 6 mit durchgezogener Linie dargestellt, ergibt sich, unter Berücksichtigung, daß weiterhin gilt: I + I' = $I_O$, der gewünschte Verlauf von I und I' (siehe Fig. 6). Die Ströme I und I' beginnen demnach später und enden früher, erreichen aber ihr Maximum zu den gleichen Zeitpunkten wie bei Verwendung einer Konstantstromquelle.

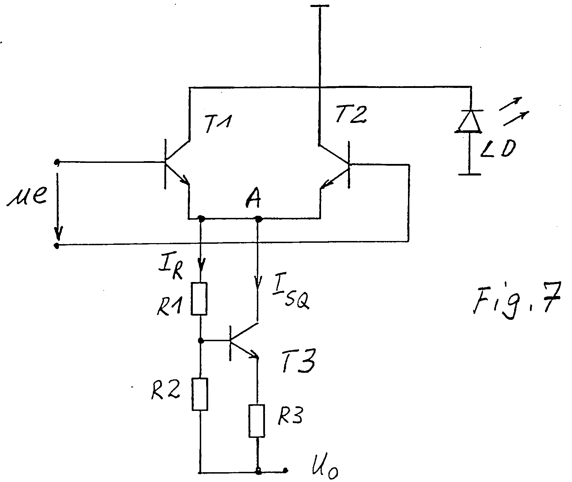

Am Knoten A der Schaltung nach Fig. 3 liegt ein Spannungsverlauf vor, der dem für den Strom $I_O$ gewünschten Verlauf entspricht. Diese Spannung kann also benutzt werden, um z.B. eine Transistorstromquelle in der gewünschten Weise zu schalten, z.B. in der in Fig. 7 dargestellten Weise. Der vom Stromschalter geschaltete Strom $I_{SQ}$ + $I_R$ wird zu einem Teil von der Transistorstromquelle bestehend aus dem Transistor T3 und dem Widerstand R3 und zum anderen Teil von der Serienschaltung der beiden Spannungsteiler-Widerstände R1 und R2 geliefert. Über den ohmschen Spannungsteiler R1, R2 wird der Strom $I_{SQ}$ entsprechend dem Verlauf der Spannung am Knoten A geschaltet.

Für die Realisierung der nach der Erfindung geschalteten Stromquelle Q gibt es natürlich weitere Ausgestaltungsmöglichkeiten. Es ist auch prinzipiell möglich die Stromquelle bei Pegelwechsel des Ansteuersignals ue nicht vollständig sondern nur teilweise abzuschalten. Je nach Einsatz lassen sich die Maßnahmen der Erfindung auch bei anderen Sendeelementen anwenden, wo ähnliche Probleme auftreten (Einschaltvorgang abweichend vom Ausschaltvorgang).

**Patentansprüche**

1. Treiberstufe für ein optisches Sendeelement, insbesondere eine Laserdiode (LD), in Stromschaltertechnik (T1, T2) mit einer Versorgungsstromquelle (Q) für den Stromschalter, dadurch gekennzeichnet, daß die Versorgungsstromquelle (Q) so ausgebildet ist, daß sie beim Pegelwechsel des Stromschalter-Eingangssignals (ue) jeweils kurzzeitig vollständig oder teilweise abschaltet.

2. Treiberstufe nach Anspruch 1, dadurch gekennzeichnet, daß die Versorgungsstromquelle (Q) aus einer emitter- oder sourcegegengekoppelten Transistorstufe (T3) besteht, deren Steuerelektrode über einen Spannungsteiler (R1, R2) an den gemeinsamen Verbindungsknoten (A) der Stromschalterzweige (T1, T2) angeschlossen ist.

3. Treiberstufe nach einem der Ansprüche 1 oder 2, dadurch gekennzeichnet, daß die Abschaltzeit der Versorgungsstromquelle (Q) so gewählt ist, daß das Augendiagramm der Lichtausgangsleistung der Laserdiode (LD) eine große Öffnung aufweist.

Fig. 1

Fig. 2

T1 I I' T2

A

ue I₀

Q

U₀

Fig. 3

LD

Fig. 4

ue

t

I

t

P_L

t

Fig. 5

Fig. 6

Fig. 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| X | PATENT ABSTRACTS OF JAPAN vol. 12, no. 291 (E-644) 9. August 1988 & JP-A-63 067 791 (NEC CORP) | 1,3 | H01S3/096 H03K17/04 H05B33/08 |
| Y | * Zusammenfassung * | 2 | |
| D,Y | IEEE JOURNAL OF SOLID-STATE CIRCUITS, Bd.27, Nr.8, August 1992, NEW YORK US Seiten 1207 - 1210 C.T. CHUANG ET AL 'High speed low power ECL circuit with AC coupled self biased dynamic current source and active pull down emitter follower stage' | 2 | |
| D,A | * Abbildung 1C * | 1,3 | |
| A | FREQUENZ, Bd.46, Nr.1/2, Januar 1992, BERLIN DE Seiten 31 - 37 H.M. REIN 'Design of silicon bipolar laser and line-driver IC with adjustable pulse shape and amplitude for data rates around and above 10 Gbit/s' * das ganze Dokument * | 1,3 | |

**RECHERCHIERTE SACHGEBIETE (Int.Cl.5)**

H01S
H03K
H05B
H04B

Der vorliegende Recherchenbericht wurde für alle Patentansprüche erstellt

| Recherchenort | Abschlußdatum der Recherche | Prüfer |
|---|---|---|
| DEN HAAG | 15. September 1994 | Claessen, L |